# EUROPEAN PATENT SPECIFICATION

(11) **EP 0 661 742 B1**
(45) Date of publication and mention of the grant of the patent: **09.09.1998**
(21) Application number: 94309582.8
(22) Date of filing: 20.12.1994
(51) Int. Cl.: H01L 21/31, H01L 21/28, H01L 23/485, H01L 23/31

(54) **Method of passivating an integrated circuit**
Verfahren zur Passivierung einer integrierten Schaltung
Procédé de passivation d'un circuit intégré

(30) Priority: 29.12.1993 US 175088
(43) Date of publication of application: 05.07.1995
(73) Proprietor: DOW CORNING CORPORATION, Midland, Michigan 48686-0994 (US)
(72) Inventor: Michael, Keith Winton, Midland, Michigan (US)
(74) Representative: Vandamme, Luc Johan Roger

(56) References cited:
- EP-A- 0 396 276
- US-A- 4 756 977
- US-A- 5 136 364
- PATENT ABSTRACTS OF JAPAN vol. 12, no. 239 (E-630) 7 July 1988 & JP-A-63 031 138 (FUJITSU LTD)
- PATENT ABSTRACTS OF JAPAN vol. 11, no. 110 (E-496) 7 April 1987 & JP-A-61 259 557 (NEC CORP)

## Description

The present invention relates to integrated circuits which are protected from the environment. These circuits are inexpensive to fabricate and have improved performance and reliability.

Modern electronic circuits must be able to withstand a wide variety of environmental conditions such as moisture, ions, heat and abrasion. A significant amount of work has been directed toward various protective measures to minimize the exposure of such circuits to the above conditions and thereby increase their reliability and life.

Many prior art processes for protecting electronic circuits have involved sealing or encapsulating the circuits after they have been interconnected. For example, it is known to use materials such as silicones, polyimides, epoxies, other organics, plastics and the like to encapsulate interconnected circuits. The above materials, however, are of only limited value since most are permeable to environmental moisture and ions.

Similarly, interconnected circuits have also been sealed within ceramic packages. This process has proven to be relatively effective in increasing device reliability and is currently used in select applications. The added size, weight and cost involved in this method, however, inhibits widespread application in the electronic industry.

The use of lightweight ceramic protective coatings on electronic devices has also been suggested. For instance, U.S. Patents 4,756,977 and 4,749,631 describe the use of ceramic silica coatings derived from hydrogen silsesquioxane and silicate esters, respectively, as well as additional ceramic layers as hermetic barriers. We have found that when such coatings are applied specifically to integrated circuits at the wafer stage; and even though the bond pads are subsequently opened by removing a portion of the coating, the resultant circuits remain sealed and exhibit increased reliability and life.

Sealing circuits at the wafer stage is also known in the art. For example, it is known to coat fabricated integrated circuits with ceramic materials such as silica and/or silicon nitride by chemical vapor deposition (CVD) techniques. These coatings are then etched back at the bond pads for the application of leads. The wafers coated in this manner, however, have inadequate reliability and life.

Similarly, U.S. Patent 5,136,364 teaches a method for sealing integrated circuits at the wafer stage. The process described therein comprises applying a first passivation coating which overlaps the edges of an aluminum bonding pad on an integrated circuit, applying a sequence of conductive layers comprising a barrier metal layer and a noble metal layer which overlay the aluminum bond pad and which has edges which overlap the first passivation layer and then applying a second passivation layer which overlaps the edges of the sequence of conductive layers. This process, however, is complex and is impractical in conventional semiconductor fabricating facilities.

In EP 0396276, there is described a method of manufacturing a semiconductor device which includes the formation of a wiring layer on a semiconductor substrate, forming a protective film on the wiring layer, forming a first window to expose a first surface portion of the wiring layer, forming a metal film continuously on the protective film and on the first surface, forming a mask layer on the metal film, forming a second window to expose a second surface portion of the wiring layer positioned within the first surface portion and performing electrolytic plating, followed by removing the metal layer. In the abstract of JP 61259557 there is described a semiconductor device, wherein the corrosion of a bonding pad is eliminated by forming a polycrystalline silicon layer on the bonding pad and forming an aluminium layer thereon. In the abstract of JP 63031138, there is described a method to manufacture a semiconductor device with improved adhesive force of a metallic bump. In US patent 4756977 there is described a process for forming on a substrate a multilayer ceramic or ceramic-like coating, which is stated to be useful for coating electronic devices.

We now introduce a simple process for the protection of integrated circuits which involves sealing the bond pads of integrated circuits with non-corroding metal layers and sealing the remainder of the devices with passivation layers.

The present invention relates to sealed integrated circuits. These circuits comprise a circuit subassembly having bond pads. On the bond pads is a non-corroding metal layer which inhibits degradation of the metal comprising the bond pads. A passivation layer comprising 1 or more ceramic coatings covers the surface of the subassembly and the non-corroding metal. Openings are provided in the passivation to expose at least a portion of the non-corroding metal for interconnection.

The present invention is based on our finding that integrated circuits can be sealed by the application of non-corroding metals over the bond pads and ceramic layers over the remainder of the circuits. The non-corroding metal layers inhibit degradation of the bond pads and the passivation layer inhibits degradation of the remainder of the circuit. The resultant circuits are sealed from the environment and can be easily interconnected by bonding (e.g., TAB, flip-chip, wire bonding, etc. with gold, copper, solder, etc.) to the non-corroding metal layer.

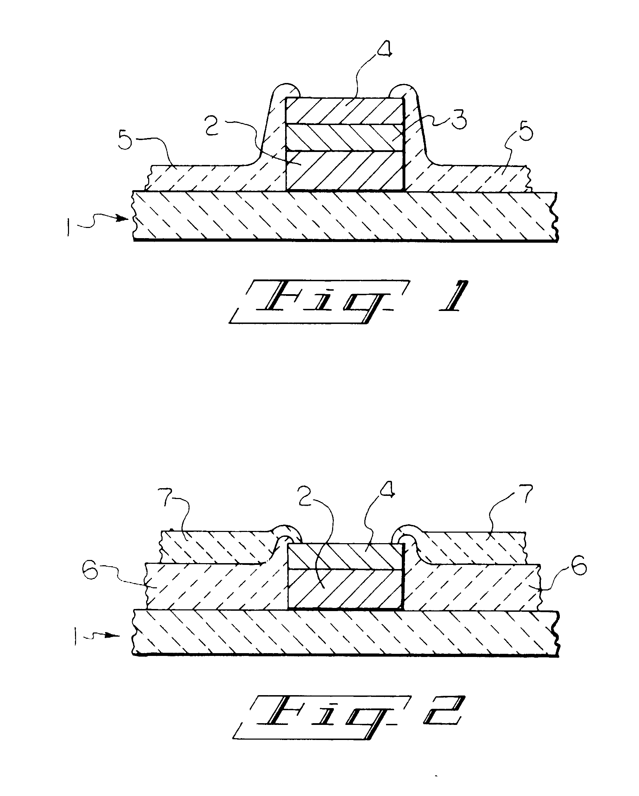

The integrated circuit subassemblies used in the process of this invention are not critical and any which are known in the art and/or produced commercially are useful herein. The processes used to produce such circuits are also known and not critical to the invention. Exemplary of such circuits are those comprising a semiconductor substrate (eg., silicon, gallium arsenide, etc.) having an epitaxial layer grown thereon. This epitaxial layer is appropriately doped to form the PN-junction regions which constitute the active regions of the device. These active regions are diodes and transistors which form the integrated circuit when appropriately interconnected by a properly patterned metallic layer. This metallic interconnect layer terminates at the bond pads on the exterior surface of the circuit subassembly. Such circuits are represented in Figures 1 and 2 as (1) and the bond pads are represented in these Figures as (2).

Figure 1 is a cross-sectional view of a circuit of this invention having a diffusion barrier metal layer and non-corroding metal layer on the bond pad and a single ceramic coating as the passivation layer.

Figure 2 is a cross-sectional view of a circuit of this invention having a non-corroding metal layer on the bond pad and two ceramic coatings as the passivation layer.

In the present invention, the above integrated circuit subassemblies are sealed by (A) applying a non-corroding metal layer (layer 4 in Figure 2) or a barrier metal layer and a non-corroding metal layer (layers 3 and 4, respectively, in Figure 1) over at least a portion of the top surfaces of the bond pads; and (B) applying a passivation layer comprising 1 or more ceramic coatings over the surface of this subassembly (layers 5, 6 and 7 in Figures 1 and 2).

The non-corroding metal layer used herein is known in the art for use within integrated circuits for building the multiple layers of the circuit. The material used for this layer is not critical and can comprise any which is stable in the environment, electrically conductive and useful for interconnecting the circuit. Examples of such materials include gold, copper, silver, tungsten, platinum, solder and silver filled epoxy.

The method for applying this layer or layers is likewise not critical. Examples of such processes include various physical vapor deposition (PVD) techniques such as sputtering and electron beam evaporation or merely dispensing the material on the bond pad. These and other processes are known in the art for use within integrated circuits for building the multiple layers of the circuit and are functional herein.

It should be noted that the materials of the bond pad (eg., aluminum) may be incompatible with the materials of the non-corroding metal layer (eg, gold) such that when they are brought into contact with each other under certain circumstances intermetallic formation ("purple plague") can damage the circuit. To prevent such damage, it is suggested to first apply a diffusion barrier metal layer to the bond pads followed by application of the conductive layers as set forth above. The diffusion barrier metal layers useful herein are known in the art for use within integrated circuits for building the multiple layers of the circuit. Generally, such layers comprise metals and metal alloys such as tungsten, titanium-tungsten and titanium nitride.

The method for forming the barrier metal layers is not critical and many techniques are known in the art. A common approach involves sputtering the barrier metal layer on the surface of the circuit followed by etching.

After the bond pads have been sealed with either the non-corroding metal layer or the barrier metal/non-corroding metal layer, the surface of the circuit subassembly is coated with a passivation layer. This passivation layer comprises one or more ceramic coatings.

The method for applying the passivation layer is not critical and nearly any approach can be used. Generally, however, the top surface of the subassembly, including the bond pads, is entirely covered with ceramic coating(s) and then the coating(s) covering the bond pads is etched to allow interconnection of the circuit. One example of a method for depositing these coatings involves applying a silicon-containing ceramic material by a process comprising coating the circuit with a composition comprising a preceramic silicon-containing material as claimed followed by converting the preceramic silicon-containing material to a ceramic. Typically, the preceramic silicon-containing material is converted to a ceramic by heating it to a sufficient temperature. This approach is particularly advantageous in that the resultant coating is planar in addition to being hermetic.

As used herein, the term "preceramic silicon-containing material" describes material which can be rendered sufficiently flowable to impregnate and coat the surface of a circuit and which can be subsequently converted to a solid layer exhibiting properties generally recognized by those skilled in the art as characteristic of a ceramic. These materials include precursors to silicon oxides, silicon nitride, silicon oxynitride, silicon oxycarbide, silicon carbonitride, silicon oxycarbonitride and silicon carbide.

The preferred preceramic silicon-containing materials to be used in the process of this invention are precursors to silicon oxides, especially silica. The silica precursors which may be used are hydrogen silsesquioxane resin (H-resin), hydrolyzed or partially hydrolyzed RₙSi(OR)₄₋ₙ, or combinations of the above, in which each R is independently an aliphatic, alicyclic or aromatic substituent of 1-20 carbon atoms, preferably 1-4, such as an alkyl (e.g., methyl, ethyl and propyl), alkenyl (e.g., vinyl or allyl), alkynyl (e.g., ethynyl), cyclopentyl, cyclohexyl and phenyl and n is 0-3, preferably 0 or 1.

H-resin is used in this invention to describe a variety of hydridosilane resins having units of the structure HSi(OH)ₓ(OR)_{y}O_{z/2} in which each R is independently an organic group which, when bonded to silicon through the oxygen atom, forms a hydrolyzable substituent, x = 0-2, y = 0-2, z = 1-3 and x + y + z = 3. These resins may be either fully condensed (x = 0, y = 0 and z = 3) or they may be only partially hydrolyzed (y does not equal 0 over all the units of the polymer) and/or partially condensed (x does not equal 0 over all the units of the polymer). Although not represented by this structure, various units of these resins may have either zero or more than one Si-H bond due to various factors involved in their formation and handling. Exemplary of substantially condensed H-resins (less than 300 ppm silanol) are those formed by the process of U.S. Patent 3,615,272. This polymeric material has units of the formula (HSiO_{3/2})ₙ in which n is generally 8-1000. The preferred resin has a number average molecular weight of from 800-2900 and a weight average molecular weight of between 8000-28,000 (obtained by GPC analysis using polydimethylsiloxane as a calibration standard). When heated sufficiently, this material yields a ceramic coating essentially free of SiH bonds.

Exemplary H-resin which may not be fully condensed include those of U.S. Patent 5,010,159 or those of U.S. Patent 4,999,397. Exemplary H-resin which is not fully hydrolyzed or condensed is that formed by a process which comprises hydrolyzing a hydrocarbonoxy hydridosilane with water in an acidified oxygen-containing polar organic solvent.

A platinum, rhodium or copper catalyst may be admixed with the hydrogen silsesquioxane to increase the rate and extent of its conversion to silica. Any platinum, rhodium or copper compound or complex that can be solubilized in this solution will be operable. For instance, an organoplatinum composition such as platinum acetylace tonate or rhodium catalyst RhCl₃[S(CH₂CH₂CH₂CH₃)₂]₃, obtained from Dow Corning Corporation, Midland, Michigan is suitable. The above catalysts are generally added to the solution in an amount of between 5 and 500 ppm platinum or rhodium based on the weight of resin.

The second type of silica precursor material useful herein includes hydrolyzed or partially hydrolyzed compounds of the formula RₙSi(OR)₄₋ₙ in which R and n are as defined above. Some of these materials are commercially available, for example, under the tradename ACCUGLASS (Allied Signal). Specific compounds of this type include methyltriethoxysilane, phenyltriethoxysilane, diethyldiethoxysilane, methyltri-methoxysilane, dimethyldimethoxysilane, phenyltri-methoxysilane, vinyltrimethoxysilane, tetramethoxysilane, tetraethoxysilane, tetrapropoxysilane and tetrabutoxysilane. After hydrolysis or partial hydrolysis of these compounds, the silicon atoms therein may be bonded to C, OH or OR groups, but a substantial portion of the material is believed to be condensed in the form of soluble Si-O-Si resins. Compounds in which x = 2 or 3 are generally not used alone as volatile cyclic structures are generated during pyrolysis, but small amounts of said compounds may be cohydrolyzed with other silanes to prepare useful preceramic materials.

In addition to the above SiO₂ precursors, other ceramic oxide precursors are also used in combination with the above SiO₂ precursors. These precursors include compounds of various metals such as aluminum, titanium, zirconium, tantalum, niobium and/or vanadium, as well as various non-metallic compounds such as those of boron or phosphorous which may be dissolved in solution, hydrolyzed and subsequently pyrolyzed at relatively low temperatures to form ceramic oxides.

The above ceramic oxide precursor compounds generally have one or more hydrolyzable groups bonded to the above metal or non-metal, depending on the valence of the metal. The number of hydrolyzable groups to be included in these compounds is not critical as long as the compound is soluble in the solvent. Likewise, selection of the exact hydrolyzable substituent is not critical since the substituents are either hydrolyzed or pyrolyzed out of the system. Typical hydrolyzable groups include alkoxy, such as methoxy, propoxy, butoxy and hexoxy; acyloxy, such as acetoxy; and other organic groups bonded to said metal or non-metal through an oxygen such as acetylacetonate or an amino groups. Specific compounds include zirconium tetracetylacetonate, titanium dibutoxy diacetylacetonate, aluminum triacetyl-acetonate, tetraisobutoxy titanium and Ti(N(CH₃)₂)₄.

When SiO₂ is to be combined with one of the above ceramic oxide precursors, generally it is used in an amount such that the final ceramic contains 70 to 99.9 percent by weight SiO₂.

Examples of other silicon-containing preceramic materials include silicon carbonitride precursors such as hydridopolysilazane (HPZ) resin and methylpolydisilylazane (MPDZ) resin. Processes for the production of these materials are described in U.S. Patents 4,540,803 and 4,340,619, respectively. Examples of silicon carbide precursors include polycarbosilanes and examples of silicon nitride precursors include polysilazanes. Oxygen can be incorporated into the ceramics resulting from the above precursors or the precursors can be converted to silica by pyrolyzing them in an oxygen-containing environment.

The above silicon-containing preceramic material is then used to coat the integrated circuit. The material can be used in any practical form but it is preferred to use a liquid comprising the preceramic material in a suitable solvent. If this solution approach is used, the preceramic liquid is generally formed by simply dissolving or suspending the preceramic material in a solvent or mixture of solvents. Various facilitating measures such as stirring and/or heat may be used to assist in the dissolution/dispersion. The solvents which may be used in this method include alcohols such as ethyl or isopropyl; aromatic hydrocarbons such as benzene or toluene; alkanes such as n-heptane or dodecane; ketones; cyclic dimethylpolysiloxanes; esters or glycol ethers; in an amount sufficient to dissolve or disperse the above materials to low solids. For instance, enough of the above solvent can be included to form a 0.1-85 weight percent solution.

The circuit is then coated with this liquid by means such as spin, spray, dip or flow coating and the solvent is allowed to evaporate. Any suitable means of evaporation such as simple air drying by exposure to an ambient environment or the application of a vacuum may be used.

Although the above described methods primarily focus on using a solution approach, one skilled in the art would recognize that other equivalent means (eg., melt impregnation) would also function herein and are contemplated by this invention.

The preceramic material is then typically converted to the silicon-containing ceramic by heating it to a sufficient temperature. Generally, the temperature is in the range of 50 to 1000°C. depending on the pyrolysis atmosphere and the preceramic compound. Preferred temperatures are in the range of 50 to 600°C. and more preferably 50-400°C. Heating is generally conducted for a time sufficient to ceramify, generally up to about 6 hours, with less than 2 hours being preferred.

The above heating may be conducted at any effective atmospheric pressure from vacuum to superatmospheric and under any effective oxidizing or non-oxidizing gaseous environment such as those comprising air, O₂, an inert gas (N₂, etc.), ammonia, amines, moisture and N₂O.

Any method of heating such as the use of a convection oven, rapid thermal processing, hot plate or radiant or microwave energy is generally functional herein. The rate of heating, moreover, is also not critical, but it is most practical and preferred to heat as rapidly as possible.

Additional examples of methods for the application of the passivation include PVD or CVD of coatings such as silicon oxygen containing coatings, silicon containing coatings, silicon carbon containing coatings, silicon nitrogen containing coatings, silicon oxygen nitrogen coatings, silicon nitrogen carbon containing coatings, silicon oxygen carbon containing coatings, silicon oxygen carbon nitrogen containing coatings and/or diamond like carbon coatings.

The materials and methods for the formation of these ceramic coatings are not critical to the invention and many are known in the art. Examples of applicable methods include a variety of CVD techniques such as conventional CVD; photochemical vapor deposition; plasma enhanced CVD (PECVD), electron cyclotron resonance (ECR), jet vapor deposition and a variety of PVD techniques such as sputtering, electron beam evaporation and the like. These processes involve either the addition of energy (in the form of heat or plasma) to a vaporized species to cause the desired reaction or the focusing of energy on a solid sample of the material to cause its deposition.

In conventional CVD, the coating is deposited by passing a stream of the desired precursor gases over a heated substrate. When the precursor gases contact the hot surface, they react and deposit the coating. Substrate temperatures in the range of 100-1000°C. are sufficient to form these coatings in several minutes to several hours, depending on the precursors and the thickness of the coating desired. If desired, reactive metals can be used in such a process to facilitate deposition.

In PECVD, the desired precursor gases are reacted by passing them through a plasma field. The reactive species thereby formed are then focused at the substrate and readily adhere. Generally, the advantage of this process over CVD is that lower substrate temperature can be used. For instance, substrate temperatures of 20 to 600°C. are functional.

The plasma used in such processes can comprise energy derived from a variety of sources such as electric discharges, electromagnetic fields in the radio-frequency or microwave range, lasers or particle beams. Generally preferred in most plasma deposition processes is the use of radio frequency (10 kHz-10² MHz) or microwave (0.1-10 GHz) energy at moderate power densities (0.1-5 watts/cm²). The specific frequency, power and pressure, however, are generally tailored to the precursor gases and the equipment used.

Examples of suitable processes for the deposition of the silicon containing coating described above include (a) the CVD of a silane, halosilane, halodisilane, halopolysilane or mixtures thereof, (b) the PECVD of a silane, halosilane, halodisilane, halopolysilane or mixtures thereof or (c) the metal assisted chemical vapor deposition (MACVD) of a silane, halosilane, halodisilane, halopolysilane or mixtures thereof.

Examples of suitable processes for the deposition of the silicon carbon containing coating described above include (1) the CVD of a silane, alkylsilane, halosilane, halodisilane, halopolysilane or mixtures thereof optionally in the presence of an alkane of one to six carbon atoms or an alkyl-silane, (2) the PECVD of a silane, alkylsilane, halosilane, halodisilane, halopolysilane or mixtures thereof optionally in the presence of an alkane of one to six carbon atoms or an alkylsilane or (3) the PECVD of a silacyclobutane or disilacyclobutane as described in U.S. Patent 5,011,706.

Examples of suitable processes for the deposition of the silicon oxygen carbon containing coating described above include (1) the CVD of a silane, alkylsilane, halosilane, halodisilane, halopolysilane or mixtures thereof optionally in the presence of an alkane of one to six carbon atoms or an alkylsilane and further in the presence of an oxidizing gas such as air, oxygen, ozone, nitrous oxide and the like, (2) the PECVD of a silane, alkylsilane, halosilane, halodisilane, halopolysilane or mixtures thereof optionally in the presence of an alkane of one to six carbon atoms or an alkylsilane and further in the presence of an oxidizing gas such as air, oxygen, ozone, nitrous oxide and the like or (3) the PECVD of a silacyclobutane or disilacyclobutane as described in U.S. Patent 5,011,706, in the presence of an oxidizing gas such as air, oxygen, ozone, nitrous oxide and the like.

Examples of suitable processes for the deposition of the silicon nitrogen containing coating described above include (A) the CVD of a silane, halosilane, halodisilane, halopolysilane or mixtures thereof in the presence of ammonia, (B) the PECVD of a silane, halosilane, halodisilane, halopolysilane or mixtures thereof in the presence of ammonia, (C) the PECVD of a SiH₄ - N₂ mixture such as that described by Ionic Systems or that of Katoh in the Japanese Journal of Applied Physics, vol. 22, #5, pp. 1321-1323 or (D) reactive sputtering such as that described in Semiconductor International, p 34, August 1987.

Examples of suitable processes for the deposition of the silicon oxygen nitrogen containing coating described above include (A) the CVD of a silane, halosilane, halodisilane, halopolysilane or mixtures thereof in the presence of ammonia and an oxidizing gas such as air, oxygen, ozone, nitrous oxide and the like, (B) the PECVD of a silane, halosilane, halodisilane, halopolysilane or mixtures thereof in the presence of ammonia and an oxidizing gas such as air, oxygen, ozone, nitrous oxide and the like, (C) the PECVD of a SiH₄ - N₂ mixture such as that described by Ionic Systems or that of Katoh in the Japanese Journal of Applied Physics, vol. 22, #5, pp. 1321-1323 in the presence of an oxidizing gas such as air, oxygen, ozone, nitrous oxide and the like or (D) reactive sputtering such as that described in Semiconductor International, p 34, August 1987 in the presence of an oxidizing gas such as air, oxygen, ozone, nitrous oxide and the like.

Examples of suitable processes for the deposition of the silicon oxygen containing coating described above include (A) the CVD of a silane, halosilane, halodisilane, halopolysilane or mixtures thereof in the presence of an oxidizing gas such as air, oxygen, ozone, nitrous oxide and the like, (B) the PECVD of a silane, halosilane, halodisilane, halopolysilane or mixtures thereof in the presence of an oxidizing gas such as air, oxygen, ozone, nitrous oxide and the like, (c) the CVD or PECVD of tetraethylorthosilicate, methyltrimethoxysilane, methylhydrogensiloxanes, dimethylsiloxanes and the like in the presence of an oxidizing gas such as air, oxygen, ozone, nitrous oxide and the like or (d) the CVD or PECVD of hydrogen silsesquioxane resin in the presence of an oxidizing gas such as air, oxygen, ozone, nitrous oxide and the like as described in U.S. Patent 5,165,955.

Examples of suitable processes for the deposition of the silicon carbon nitrogen containing coating described above include (i) the CVD of hexamethyldisilazane, (ii) the PECVD of hexamethyldisilazane, (iii) the CVD of silane, alkylsilane, halosilane, halodisilane, halopolysilane or mixture thereof optionally in the presence of an alkane of one to six carbon atoms or an alkylsilane and further in the presence of ammonia or (iv) the PECVD of a silane, alkylsilane, halosilane, halodisilane, halopolysilane or mixture thereof optionally in the presence of an alkane of one to six carbon atoms or an alkylsilane and further in the presence of ammonia.

Examples of suitable processes for the deposition of the silicon oxygen carbon nitrogen containing coating described above include (i) the CVD of hexamethyldisilazane in the presence of an oxidizing gas such as air, oxygen, ozone, nitrous oxide and the like, (ii) the PECVD of hexamethyldisilazane in the presence of an oxidizing gas such as air, oxygen, ozone, nitrous oxide and the like, (iii) the CVD of silane, alkylsilane, halosilane, halodisilane, halopolysilane or mixture thereof optionally in the presence of an alkane of one to six carbon atoms or an alkylsilane and further in the presence of ammonia and an oxidizing gas such as air, oxygen, ozone, nitrous oxide and the like or (iv) the PECVD of a silane, alkylsilane, halosilane, halodisilane, halopolysilane or mixture thereof optionally in the presence of an alkane of one to six carbon atoms or an alkylsilane and further in the presence of ammonia and an oxidizing gas such as air, oxygen, ozone, nitrous oxide and the like.

Examples of suitable processes for the deposition of the diamond-like carbon coating described above include exposing the substrate to an argon beam containing a hydrocarbon in the manner described in NASA Tech Briefs, November 1989 or by one of the methods described by Spear in J. Am. Ceram. Soc., 72, pp. 171-191 (1989).

It should be noted that the passivation may be doped with other agents, if desired. For instance, the coatings may be doped with boron, phosphorous or carbon to modify its characteristics.

Either one or more of the above coatings may be used as the passivation. In a preferred embodiment of the invention, a silicon-containing ceramic layer derived from a preceramic silicon-containing material is used as a first planar layer and a second layer of a material such as silicon nitride or silicon carbide is applied on top of the first layer by CVD.

After the passivation has been applied, the coating covering the bond pad metallization is etched or partially etched to expose the top surface of the non-corroding metal layer to allow for interconnection of the circuit. In one embodiment of the invention, the passivation on the entire top surface of the bond pad can be removed. In the preferred embodiment, however, only a portion of the passivation on the top surface of bond pad is removed such that the passivation overlaps the edges and the top surface of the bond pad. It should be noted, however, that other approaches which result in open bond pads may also be used (eg., depositing the coating only around the bond pads).

The method of etching is not critical and nearly any process known in the art will function herein. This includes dry etching (eg., with plasma), wet etching (eg., with aqueous hydrofluoric acid) and/or laser ablation.

The resultant circuits are hermetically sealed such that they can be handled and/or transported without damage. In addition, either of the passivation layers may absorb UV or visible light or contain pigments or fillers which absorb UV or visible light to prevent damage and inhibit inspection.

After interconnection, the device can also be packaged by conventional techniques known in the art. For instance, the device can be embedded within an organic encapsulant such as a polyimide, an epoxy or PARYLENE™; it can be embedded within a silicone encapsulant; it can be included in a plastic package for additional protection; or it can be contained in a module or assembly without any further primary packaging.

## Claims

1. A method of sealing an integrated circuit subassembly comprising;
supplying an integrated circuit subassembly having bond pads, wherein the subassembly does not have a passivation on its surface;
applying a non-corroding metal layer on the surface of the bond pads;
applying a passivation layer directly on the surface of the subassembly and the bond pads having the non-corroding metal layer by coating with a composition comprising a preceramic silicon-containing material which also contains compounds selected from aluminium, titanium, zirconium, tantalum, niobium, vanadium , boron and phosphorous followed by converting said material to a ceramic, said compounds forming ceramic oxides, and
etching the passivation to expose at least a portion of the non-corroding metal layer on the bond pads.

2. The method of claim 1 wherein a diffusion barrier metal layer is deposited between the bond pad and the non-corroding metal layer.

3. The method of claim 1 wherein the passivation layer is selected from silicon oxides, silicon nitride, silicon oxynitride, silicon oxycarbide, silicon carbonitride, silicon oxycarbonitride and silicon carbide.

4. The method of claim 1 wherein the passivation layer is doped with an agent selected from boron, phosphorus and carbon.

5. The method of claim 1 wherein the passivation is applied by a process selected from physical vapor deposition and chemical vapor deposition.

6. The method of claim 5 wherein the preceramic silicon-containing material is hydrogen silsesquioxane resin.

7. The method of claim 2 wherein the diffusion barrier metal layer is selected from titanium, titanium-tungsten, titanium-nitride, nickel-vanadium, chromium and nickel-chromium.

8. The method of claim 1 wherein the non-corroding metal layer is selected from gold, copper, silver, tungsten, platinum, solder and silver filled epoxy.

9. The method of claim 1 wherein the passivation layer absorbs ultraviolet or visible light.

## Patentansprüche

1. Verfahren zur Versiegelung einer Baugruppe eines integrierten Schaltkreises, umfassend:
Zurverfügungstellen einer Baugruppe eines integrierten Schaltkreises mit Kontaktierungsflächen (Bond Pads), wobei die Baugruppe keine Passivierung auf ihrer Oberfläche aufweist,
Aufbringen einer nichtkorrodierenden Metallschicht auf der Oberfläche der Bond Pads,
Aufbringen einer Passivierungsschicht direkt auf der Oberfläche der Baugruppe und den Bond Pads mit der nichtkorrodierenden Metallschicht durch Beschichten mit einer Zusammensetzung, die ein präkeramisches siliciumhaltiges Material enthält, das außerdem Verbindungen, ausgewählt aus Verbindungen von Aluminium, Titan, Zirkon, Tantal, Niob, Vanadin, Bor und Phosphor enthält, gefolgt von der Umwandlung dieses Materials zu einer Keramik, wobei die Verbindungen keramische Oxide bilden, und
Ätzen der Passivierung, um wenigstens einen Teil der nichtkorrodierenden Metallschicht auf den Bond Pads freizulegen.

2. Verfahren nach Anspruch 1, wobei eine Metallschicht als Diffusionssperre zwischen dem Bond Pad und der nichtkorrodierenden Metallschicht abgeschieden wird.

3. Verfahren nach Anspruch 1, wobei die Passivierungsschicht aus Siliciumoxiden, Siliciumnitrid, Siliciumoxynitrid, Siliciumoxycarbid, Siliciumcarbonitrid, Silicumoxycarbonitrid und Siliciumcarbid ausgewählt ist.

4. Verfahren nach Anspruch 1, wobei die Passivierungsschicht mit einem Mittel, ausgewählt aus Bor, Phosphor und Kohlenstoff, dotiert ist.

5. Verfahren nach Anspruch 1, wobei die Passivierung durch ein Verfahren aufgetragen wird, das aus physikalischem Aufdampfen (PVD) und chemischem Aufdampfen (CVD) ausgewählt ist.

6. Verfahren nach Anspruch 5, wobei das präkeramische siliciumhaltige Material ein Hydrogensilsesquioxanharz ist.

7. Verfahren nach Anspruch 2, wobei die Metallschicht als Diffusionssperre ausgewählt ist aus Titan, Titan-Wolfram, Titan-Nitrid, Nickel-Vanadin, Chrom und Nickel-Chrom.

8. Verfahren nach Anspruch 1, wobei die nichtkorrodierende Metallschicht ausgewählt ist aus Gold, Kupfer, Silber, Wolfram, Platin, Lötmetallen und mit Silber gefülltem Epoxyharz.

9. Verfahren nach Anspruch 1, wobei die Passivierungsschicht ultraviolettes oder sichtbares Licht absorbiert.

## Revendications

1. Un procédé de protection d'un sous-ensemble de circuit intégré comprenant les opérations consistant:
à fournir un sous-ensemble de circuit intégré comportant des plots de connexion, le sous-ensemble ne comportant pas de passivation sur sa surface ;
à appliquer une couche métallique non corrosive sur la surface des plots de connexion ;
à appliquer une couche de passivation directement sur la surface du sous-ensemble et sur les plots de connexion portant la couche métallique non corrosive par application en revêtement d'une composition comprenant une matière siliciée précéramique qui renferme aussi des composés choisis parmi des composés de l'aluminium, du titane du zirconium, du tantale, du niobium, du vanadium,, du bore et du phosphore, puis à convertir ladite matière en une matière céramique lesdits composés formant des oxydes céramiques ; et
à attaquer chimiquement la passivation pour exposer au moins une partie de la couche métallique non corrosive sur les plots de connexion.

2. Le procédé de la revendication 1 dans lequel une couche métallique formant barrière de diffusion est déposée entre le plot de connexion et la couche métallique non corrosive.

3. Le procédé de la revendicaticn 1 dans lequel la couche de passivation est choisie parmi les oxydes de silicium, le nitrure de silicium, l'oxynitrure de silicium, l'oxycarbure de silicium, le carbcnitrure de silicium, l'oxycarbonitrure de silicium et le carbure de silicium.

4. Le procédé de la revendication 1 dans lequel la couche de passivation est dopée par un aqent choisi parmi le bore, le phosphore et le carbone.

5. Le procédé de la revendication 1 dans lequel la passivation est appliquée par un procédé choisi parmi le dépôt physique en phase vapeur et le dépôt chimique en phase vapeur.

6. Le procédé de la revendication 5 dans lequel la matière siliciée précéramique est une résine d'hydrogénosilsesquioxane.

7. Le procédé de la revendication 2 dans lequel la couche métallique formant barrière de diffusion est choisie parmi le titane, le titane-tungstène, le titane-nitrure, le nickel-vanadium, le chrome et le nickel-chrome.

8. Le procédé de la revendication 1 dans lequel la couche métallique non corrosive est choisie parmi l'or, le cuivre, l'argent, le tungstène, le platine, la soudure et l'époxy à charge d'argent.

9. Le procédé de la revendication 1 dans lequel la couche de passivation absorbe la lumière ultraviolette ou visible.
